# EUROPÄISCHE PATENTSCHRIFT

(11) **EP 1 240 659 B1**
(45) Veröffentlichungstag und Bekanntmachung des Hinweises auf die Patenterteilung: **13.05.2009**
(21) Anmeldenummer: 00990762.7
(22) Anmeldetag: 15.12.2000
(51) Int. Cl.: H01J 37/32

(54) **ANORDNUNG ZUM EINKOPPELN VON MIKROWELLENENERGIE IN EINE BEHANDLUNGSKAMMER**
ARRANGEMENT FOR COUPLING MICROWAVE ENERGY INTO A TREATMENT CHAMBER
DISPOSITIF PERMETTANT D'INJECTER DE L'ENERGIE MICROONDE DANS UN COMPARTIMENT DE TRAITEMENT

(30) Priorität: 24.12.1999 DE 19963122
(43) Veröffentlichungstag der Anmeldung: 18.09.2002
(73) Patentinhaber: Tetra Laval Holdings & Finance SA, 1009 Pully (CH)
(72) Erfinder: MOORE, Rodney, Gardener MA 01440 (US); ESSERS, Wolf, 64331 Weiterstadt (DE)
(74) Vertreter: Weber, Roland
(86) Internationale Anmeldenummer: PCT/EP2000/012770
(87) Internationale Veröffentlichungsnummer: WO 2001/048788

(56) Entgegenhaltungen:
- WO-A-97/44503
- WO-A-99/17334
- DE-A- 19 839 612
- US-A- 4 434 742

## Beschreibung

Die Erfindung betrifft eine Anordnung zum Einkoppeln von Mikrowellenenergie in eine in einem Hohlraumresonator befindliche Behandlungskammer, insbesondere eine Plasma-CVD-Beschichtungskammer, mit einer Mikrowellenzuführung und mit einem Mikrowellenhohlleiter. Solche Anordnung ist bekannt aus WO99/17334.

Bekannt sind Vorrichtungen zur Erzeugung eines Plasmas, welches zum Beispiel der Beschichtung, Reinigung, Modifizierung und Ätzung von Substraten, aber auch zur Behandlung von medizinischen Implantaten dient. Es werden Werkstücke unterschiedlichster Formen beschichtet. Bekannte Vorrichtungen zur Erzeugung von Plasma besitzen einen ringförmigen Resonator, welchem Mikrowellen über Hohlleiter und Koaxialkabel zugeleitet werden.

Bekannt ist auch die Beschichtung von Kraftfahrzeugtanks, wobei in der Außenwand des Hohlraumresonators vier oder mehr Mikrowellenquellen in Form von Magnetrons angeordnet sind, um ein zuvor in den Tank eingeleitetes Gas mit Hilfe der eingekoppelten Mikrowellenenergie in den Plasmazustand zu aktivieren. Für einen Tank werden mindestens vier Magnetrons benötigt, und wenn mehrere Behälter gleichzeitig mit einer Innenbeschichtung versehen werden sollen, wächst die Anzahl der Magnetrons mit ihren Stromversorgungseinheiten zu einer wirtschaftlich nicht vertretbar hohen Anzahl an. Außerdem hat man festgestellt, daß die Verluste und Reflexionen der eingekoppelten Mikrowellenenergie je nach Größe und Gestalt des zu beschichtenden Behälters in einem solchen Maße unterschiedlich sind, daß für eine bestimmte Gestalt eine Anpassung erfolgen muß, welche dann für die nächste andere Gestalt nicht mehr zufriedenstellende Ergebnisse bringt. Es stellen sich andere Lasten, Verluste und Reflexionen ein, so daß für jede Art Behälter eine mehr oder weniger langwierige Anpassung und Abstimmung erforderlich werden. Man hat auch schon den Reflexionsfaktor der Mikrowellenleistung in Abhängigkeit von der Länge der Zuleitung zu einer Mikrowellenreaktionskammer untersucht, um eine optimale Abstimmung für bestimmte Frequenzen zu erreichen. Man hat eine Änderung des Verlaufes der Reflexion in Abhängigkeit von der Länge einer Zuleitung durch Einbringen unterschiedlicher Absorber in Mikrowellenhohlleiter erreicht, wobei jedoch immer eine Empfindlichkeit gegenüber Fehlanpassung infolge von Geometrieänderungen zu beobachten ist.

Aufgabe der Erfindung ist es, eine Anordnung zum Einkoppeln von Mikrowellenenergie der eingangs genannten Art so auszugestalten, daß Kunststoffbehälter mit in gewissem Grade unterschiedlicher Gestalt und Größe innen effektiv beschichtet werden können. Es soll mit anderen Worten nicht für geringe Größenabweichungen und jede unterschiedliche Gestalt von Behälter eine andere Einkopplungsanordnung oder wenigstens eine Anpassung vorgesehen werden, die Umrüstarbeiten erfordert.

Für ein Magnetron, welches bei fester Frequenz Mikrowellenenergie erzeugt, soll der Reflexionsfaktor der Leistung in Abhängigkeit von der effektiven Länge des Hohlleiters, die eine Funktion der Behälterdimensionen ist, nicht zu scharf abfallen, um neben dem Minimalwert entsprechend stark wieder anzusteigen, sondern das Verhaltern dieser Kurve soll einen gleichmäßigeren Effekt zeigen.

Überraschenderweise hat man die Aufgabe erfindungsgemäß dadurch gelöst, daß die Anordnung einen im wesentlichen zylindrischen Aufbau derart hat, daß am hinteren Ende ein erster koaxialer Hohlleiter mit als Antenne ausgebildetem Innenleiter vorgesehen ist, in der Mitte der Anordnung sich ein etwa zylindrischer Hohlleiter anschließt und am vorderen Ende ein zweiter koaxialer Hohlleiter mit Innenleiter vorgesehen ist, wobei in den zweiten koaxialen Hohlleiter durch ein Gaszuführrohr Gas einführbar ist, welches durch die eingekoppelte Mikrowellenenergie in den Plasmazustand aktivierbar ist, und wobei durch die Antenne im Plasmabereich eine TM-Mode erzeugt wird. Durch diese Maßnahmen erhält man einen etwas mäßigeren Reflexionsfaktorabfall der Leistung in Abhängigkeit von der Geometrie des Behälters mit der Folge, daß auch Behälter ungleicher Volumina und ungleicher Gestaltung doch immer noch effektiv behandelt werden können, weil genügend Mikrowellenleistung für das Zünden und Aufrechterhalten des Plasmas zur Verfügung steht, d.h. die reflektierte Leistung gering ist. Bedarf für eine komplette neue Anpassung gibt es erst dann, wenn das Volumen der behandelten Behälter sich um den Faktor zwei oder mehr verändert und entsprechend auch die Gestalt des einen Behälters gegenüber dem anderen sehr drastisch verändert ist. Durch die erfindungsgemäßen Maßnahmen kann man ohne Umrüstarbeiten unterschiedliche Behälter ähnlicher Form und Größe mit ausreichendem Wirkungsgrad behandeln.

Zu den guten Behandlungsergebnissen trägt nicht nur die im wesentlichen zylindrische Form des Hohlraumresonators bei, sondern die Vermeidung von Fehlanpassungen und die Einkopplung der Mikrowellenleistung mit gutem Wirkungsgrad gelingt auch durch die Hintereinanderanordnung der drei elektrisch unterschiedlichen Hohlleiterabschnitte, wobei der erste Hohlleiter ein koaxialer Leiter ist, der zweite ein zylindrischer Hohlleiter (in der Mitte) ist und der vordere Leiter wieder ein zweiter koaxialer Hohlleiter ist. Der große Vorteil der Anordnung dieser drei Abschnitte ist auch die Möglichkeit einer Abtrennung bzw. Abdichtung des einen Abschnittes gegenüber dem anderen. Ferner hat sich durch die Trennung dieser funktionsmäßig unterschiedlichen Abschnitte eine besondere Effektivität für das Einkoppeln der Mikrowellenleistung ergeben.

Besonders vorteilhaft ist es erfindungsgemäß ferner, wenn die Antenne des ersten koaxialen Hohlleiters Stabform hat und die Länge der Stabantenne zwischen 40 mm und 100 mm liegt. Man kann mit einer solchen Stabantenne (ebenso gut wie mit den nachfolgende beschriebenen anderen Ausführungsformen der Antennen) eine TM-Mode erreichen, d.h. transversalmagnetische Feldlinien in den drei Abschnitten der Anordnung, wobei insbesondere im Plasmabereich die Erzeugung der TM-Mode möglich ist. Die erfindungsgemäße Anordnung arbeitet auch gut mit einer Stabantenne, deren Länge zwischen 50 und 60 mm liegt. Die Stabantenne kann aus Kupfer hergestellt sein und einen Außendurchmesser von etwa 8 mm haben. Es funktionieren aber auch Außendurchmesser aus dem Größenbereich von 2 mm bis 10 mm gut.

Günstig ist es gemäß der Erfindung ferner, wenn entsprechend einer alternativen Ausführungsform die Antenne des ersten koaxialen Hohlleiters die Form einer konischen Spirale hat und die Länge der Spiralantenne zwischen 50 und 70 mm liegt. Die sogenannte archimedische Spirale ist bekannt. Sie wird in Polarkoordinaten durch die Gleichung r = α x ϕ dargestellt. Dieser archimedischen Spirale entspricht im Raum die konische Spirale. Sie ist die Bahnkurve eines Punktes, der sich auf einer mit konstanter Winkelgeschwindigkeit um eine Kegelachse drehenden Mantellinie mit konstanter Geschwindigkeit bewegt. Auch die Spiralantenne sollte zweckmäßigerweise aus Kupfer hergestellt sein mit einem Durchmesser von besonders bevorzugt etwa 3,5 mm. Es haben sich Spiralantennen mit sechs Windungen als sehr günstig erwiesen. Diese hatten eine Länge von etwa 60 mm. Aber auch Versuche mit Spiralantennen mit einer Länge zwischen 50 und 70 mm und mit 5 bis 7 Windungen arbeiteten zufriedenstellend. Als Durchmesserbereich kann man 2 bis 5 mm angeben. Betrachtet man die Kegelstumpfform der Spiralantenne, dann liegt der große Durchmesser an dem sogenannten hinteren Ende, also von dem Gaszuführrohr abliegend, während das Ende mit dem kleinen Durchmesser dem Ende des Gaszuführrohres zugewandt ist. Der größere hintere Durchmesser liegt im Größenbereich von 35 bis 50 mm und beträgt vorzugsweise 42 mm. Der kleinere Durchmesser vorn an der Spirale liegt im Bereich von 15 bis 30 mm und beträgt bei der bevorzugten Ausführungsform etwa 22 mm.

Anstelle einer Spiralantenne in Form eines hohlen Kegelstumpfes kann man sich aber auch, von außen gesehen, Stufenform vorstellen mit einem Durchmesser der hinteren drei Windungen von 35 bis 50 mm und vorzugsweise 42 mm. Der Durchmesser der vorderen drei Windungen liegt dann zweckmäßigerweise im Größenbereich von 15 bis 30 mm und beträgt vorzugsweise 22 mm.

Man kann anstelle einer konischen Spirale auch eine "Zylinderspirale" wählen, bei der zum Beispiel alle sechs Windungen der Antenne auf einem Kreisumfang mit dem Durchmesser von etwa 35 bis 50 mm und bevorzugt 42 mm laufen. Zwar handelt es sich sowohl bei der Stufenform als auch bei der Zylindermantelform nicht um eine konische Spirale im echten geometrischen Sinne, die Spiralantenne funktioniert aber auch außerhalb der Formen mit den exakten geometrischen Definitionen.

Zweckmäßig ist die Erfindung weiter dadurch ausgestaltet, daß der Innenleiter des zweiten koaxialen Hohlleiters als Gaszuführrohr ausgebildet und aus Metall hergestellt ist, welches von dem zu beschichtenden Kunststoffbehälter umgeben ist, und daß der in der Behälterträgerplatte gehalterte Behälter die Behandlungskammer bildet. Diese Ausführungsform von Einkoppelanordnung ist besonders bei der Innenbeschichtung von Kunststoffbehältern mittels Plasma nützlich. Das Plasma wird (unter anderem) durch ein eingeführtes Gas gebildet, welches schnell und effektiv über das beschriebene Gaszuführrohr in das Innere des Behälters gelangt. Dieses Gaszuführrohr aus Metall stellt den Innenleiter des zweiten koaxialen Hohlleiters am vorderen Ende der Anordnung dar. Das Gaszuführrohr ragt in den zu beschichtenden Behälter hinein, zum Beispiel eine Kunststoffflasche aus PET, von der das Gaszuführrohr umgeben ist. Dadurch bildet der Behälter die eigentliche Behandlungskammer. Entsprechende Leitungen erlauben die Einstellung eines gewünschten Unterdruckes in der Behandlungskammer, d.h. in den zu beschichtenden Behältern. Außerhalb der Behandlungskammer, aber noch innerhalb des Hohlraumresonators, können andere Drücke vorgesehen sein.

Wenn es sich bei diesen anderen Drücken wiederum um gegenüber Atmosphärendruck geringere, nämlich Unterdrücke handelt, ist es zweckmäßig, wenn erfindungsgemäß bei weiterer Ausgestaltung in dem sich in der Mitte der Anordnung befindenden zylindrischen Hohlleiter ein Quarzfenster angebracht ist, das sich quer zu der Längsachse der Anordnung erstreckt. Diese Längsachse verläuft etwa in Linie vorn Gaszuführrohr zur Antenne bzw. umgekehrt, und das Quarzfenster ist eine Platte, welche durch Mikrowellen wie ein Fenster durchdrungen werden kann. Die Quarzscheibe erlaubt eine gasdichte Trennung zwischen dem einen Hohlleiter und dem anderen und erlaubt auch die Trennung eines Hohlleiterabschnittes in zwei unterschiedliche Bereiche. Dadurch ist es möglich, den einen Bereich zu evakuieren, zum Beispiel den Bereich des zweiten koaxialen Hohlleiters, und den Bereich mit der Antenne unter Atmosphärendruck zu halten.

Es hat sich weiterhin als günstig erwiesen, wenn die Spiralantenne mittels Reibeingriff lösbar in einer hülsenförmigen Aufnahme befestigt ist. Versuche haben gezeigt, daß eine normalerweise für gut erachtete Lötverbindung zur optimalen Einkopplung der Mikrowellenenergie ungeeignet ist. Vielmehr ist zweckmäßig, wenn das hintere Ende der Spiralantenne, welches sich in Richtung der Längsachse der Anordnung erstreckt, leicht gebogen in eine hülsenförmige Aufnahme hineingesteckt und dort festgeklemmt wird, die ebenfalls in Richtung der Längsachse der Anordnung verläuft.

Weitere Vorteile, Anwendungen und Merkmale der Erfindung ergeben sich aus den folgenden Ausführungsformen in der nachfolgenden Beschreibung im Zusammenhang mit den anliegenden Zeichnungen. In diesen zeigen:
- Figur 1: eine teilweise abgebrochene und schematisierte Querschnittsansicht durch eine Einkoppelanordnung gemäß einer ersten Ausführungsform der Erfindung,
- Figur 2: eine teilweise abgebrochene, konkrete Ausführungsform mit Stabantenne und mehre- ren, nebeneinander angeordneten, innen zu beschichtenden Behältern,
- Figur 3: eine ähnliche Ansicht wie Figur 1, wobei jedoch eine Spiralantenne verwendet wird, und
- Figur 4: vergrößert die Spiralantenne mit der hülsenförmigen Aufnahme für dieselbe.

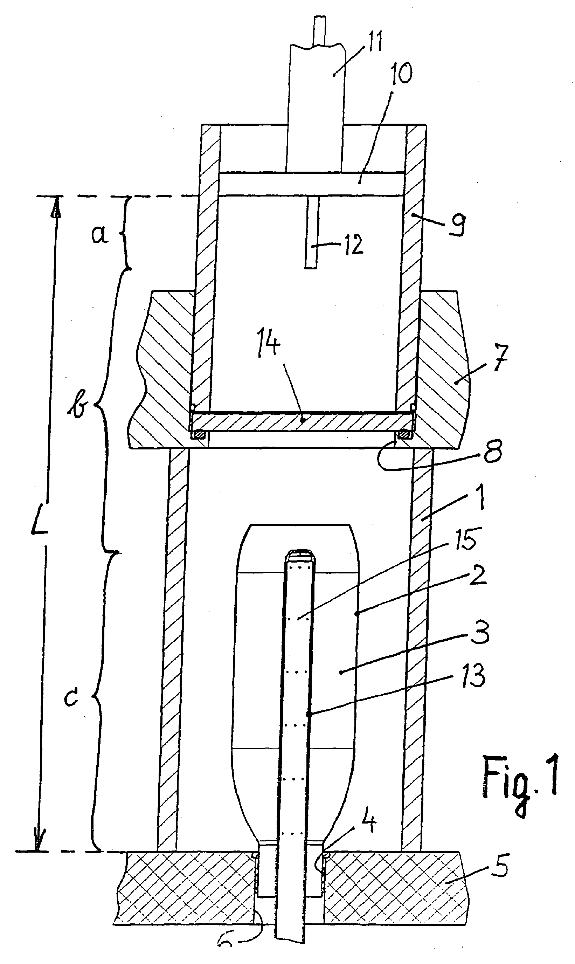

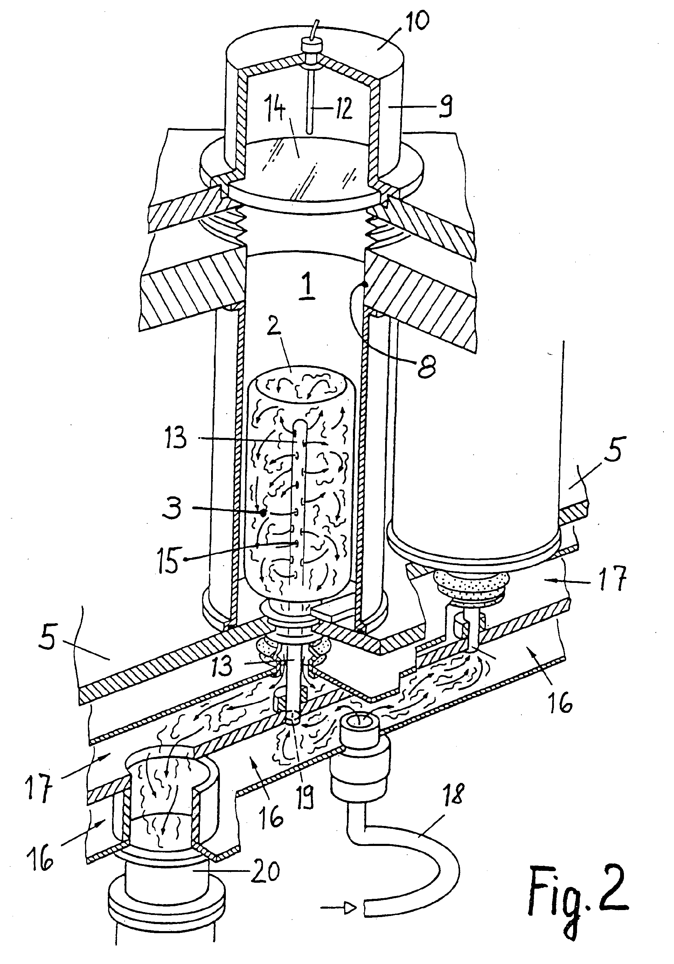

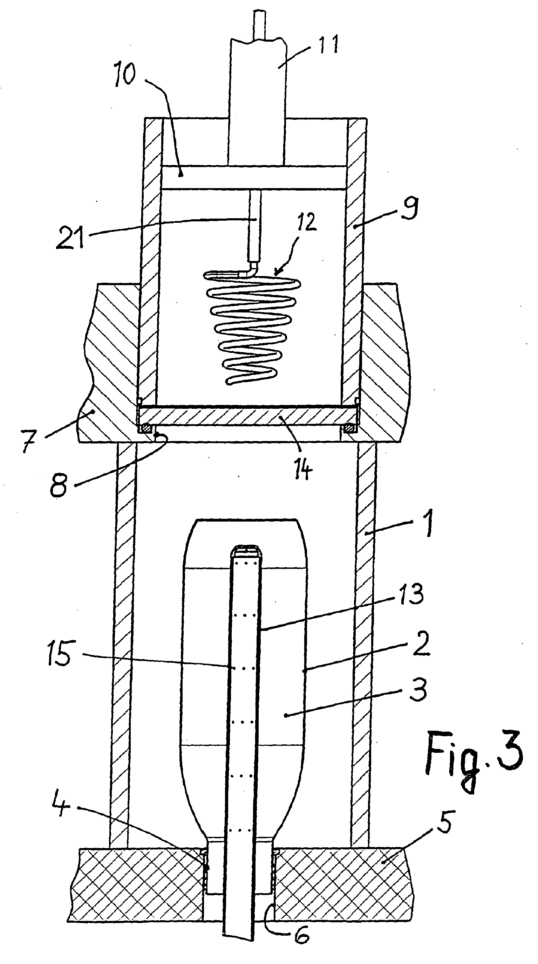

In Figur 1 und ähnlich in Figur 3 befindet sich in einem Hohlraumresonator 1 ein als Kunststoffflasche ausgestalteter Behälter 2. Durch diesen wird die Behandlungskammer 3 gebildet, die sich also im Inneren des Behälters 2 befindet. Der Behälter 2 ist nur an seinem vorderen unteren Ende über den Flaschenhals 4 offen. Oben und hinten ist er ebenso geschlossen wie an den Seiten. Der Behälter 2 wird über seinen Flaschenhals 4 von der Behälterträgerplatte 5 gehaltert. Wenn mehrere Einheiten, wie sie bei den schematisierten Darstellungen in den Figuren 1 und 3 gezeigt sind, vorgesehen sind, wie zum Beispiel bei der Ausführungsform der Figur 2, dann sind entsprechend viele Löcher 6 in der Behälterträgerplatte 5 nebeneinander für die Aufnahme der Flaschenhälse 4 vorgesehen.

Nach oben hinten ist im Abstand vorn Behälterboden etwa horizontal eine Trennwand 7 an dem Hohlraumresonator 1 befestigt. In Richtung der Längsachse der Anordnung, die in den Figuren hier nicht gezeigt und bezeichnet ist, aber von der Mitte des Loches 6 in der Behälterträgerplatte 5 vertikal nach oben senkrecht zu der Fläche der Behälterträgerplatte 5 verläuft, befindet sich in der Trennwand 7 über jedem Behälter 2 ein Loch 8 zur Aufnahme eines zylindermantelförmigen Gehäuses 9, welche nach hinten oben durch einen Gehäuseboden 10 abgedichtet ist.

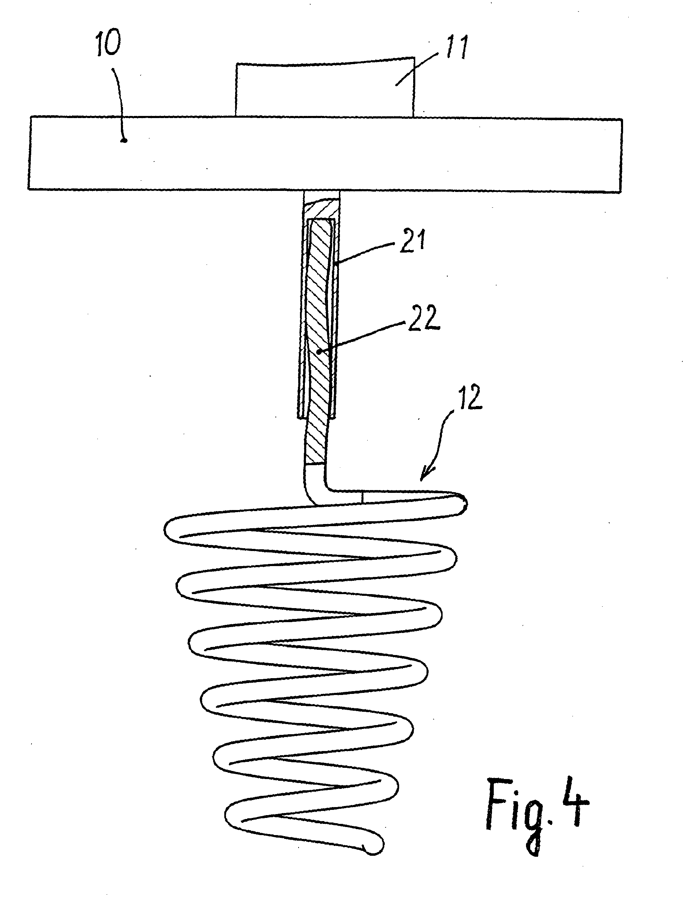

Etwa in der Mitte des Gehäusebodens 10 ist eine Mikrowellenzuführung 11 befestigt, die nach oben und hinten sowie nach außerhalb des Gehäuses 9 ragt. Diese Mikrowellenzuführung 11 ist typischerweise ein Koaxialkabel oder ein koaxialer Wellenleiter und speist eine mit 12 bezeichnete Antenne, die bei den Ausführungsformen nach den Figuren 1 und 2 Stabform hat und daher als Stabantenne bezeichnet wird. Bei der Ausführungsform der Figuren 3 und 4 hat die Antenne 12 die Form einer konischen Spirale, wird aber ebenfalls mit 12 bezeichnet. Durch diese Antenne wird die Mikrowellenenergie in das Gehäuse 9, den Hohlraumresonator 1 und in die bei diesen Ausführungsformen hier als Beschichtungskammer 3 ausgebildete Behandlungskammer 3 eingekoppelt. Insgesamt erstreckt sich der Raum mit den Hohlleitern von vorn nach hinten (in den Figuren von unten nach oben) von der inneren Oberfläche der Behälterträgerplatte 5 bis zu der inneren Oberfläche des Gehäusebodens 10. Dieser mit Mikrowellen beaufschlagte Raum hat die Gesamtlänge L. Die Anordnung dieses im wesentlichen zylindrischen Aufbaues ist in der Art, daß man elektrisch gesehen am hinteren Ende, in den Zeichnungen 1 bis 3 also oben, in dem Bereich a einen ersten koaxialen Hohlleiter hat, der einen als Antenne 12 ausgebildeten Innenleiter besitzt. Dieser endet am vorderen Ende des Bereiches a. In der Mitte schließt sich ein etwa zylindrischer Hohlleiter im Bereich b an, der keinen Innenleiter hat, und am vorderen Ende (in den Figuren nach unten zugewandt) ist im Bereich c ein zweiter koaxialer Hohlleiter vorgesehen. Letzterer hat einen als Gaszuführrohr 13 ausgestalteten Innenleiter.
Am vorderen unteren Ende des zylindermantelförmigen Gehäuses 9 ist - noch in der Trennwand 7 angeordnet - ein Quarzfenster 14 befestigt, durch welches der Raum in dem Hohlraumresonator 1 von dem im Gehäuse 9 gasdicht derart abtrennbar ist, daß im Gehäuse 9 der Druck der enthaltenen Gase anders sein kann als in dem Hohlraumresonator 1.

In letzteren kann ein Gasgemisch durch das Gaszuführrohr 13 von vorn und unten entsprechend den in Figur 2 unten gezeigten gebogenen Pfeilen eingeführt werden.

Ohne den Behälter 2 kann das Plasma in dem Hohlraumresonator 1 durch Einwirken der Mikrowellenenergie auf das Gasgemisch erzeugt und aktiviert werden und danach gegebenenfalls in andere Räume weitergeblasen werden.

Bei der hier gezeigten Ausführungsform ist jedoch der Behälter 2 über den Hals seiner Öffnung in der Behälterträgerplatte dichtend derart eingesetzt, daß das Gas für die Plasmabildung nach Austreten aus den Löchern 15 ganz innerhalb des Volumens des Behälters 2 verbleibt, wie anschaulich in Figur 2 gezeichnet ist. Der sogenannte Plasmabereich liegt dann im wesentlichen innerhalb des vorderen unteren Bereiches c in dem Hohlraumresonator 1.

Unabhängig von der körperlichen Ausgestaltung des zylindermantelförmigen Gehäuses 9 einerseits, dem sich nach vorn unten der Hohlraumresonator 1 andererseits anschließt, wird die Länge des am hinteren Ende befindlichen ersten koaxialen Hohlleiters (im Bereich a) durch die Länge der Antenne 12 definiert. Im Bereich b, wo der zylindrische Hohlleiter keinen Innenleiter hat, ist der im wesentlichen zylinderförmige Raum, auch wenn er durch unterschiedliche Gehäuseteile gebildet ist, die gegebenenfalls unterschiedlichen Durchmesser haben können, durch den Abstand der Antenne 12 einerseits und des freien inneren Endes des Gaszuführrohres 13 andererseits bestimmt. Schließlich ist am vorderen Ende im Bereich c der zweite koaxiale Hohlleiter durch die Länge seines Innenleiters bestimmt, also durch die Länge des Gaszuführrohres 13. Dessen Länge wird von der inneren Oberfläche der Behälterträgerplatte 5 bis zum oberen, hinteren, inneren Ende des Gaszuführrohres 13 gemessen.

Die Stabantenne nach den Figuren 1 und 2 hat eine Länge von 55 mm und besteht aus einem Kupferdraht mit einem Außendurchmesser von 8 mm.

Bei der Ausführungsform der Figur 2 werden Einkoppelanordnungen für die Behandlung einer Vielzahl von Kunststoffflaschen gezeigt. Die rechte Anordnung ist nur von außen zu sehen, während die linke Anordnung aufgeschnitten ist. Bei jeder Einheit werden die Mikrowellen durch die Antenne 12 über das Gehäuse 9 in den Hohlraumresonator 1 gekoppelt. Die Antenne 12 verläuft längs der Längsmittelachse, welche sich durch die gesamte Anordnung von vorn nach hinten, in Figur 2 also von unten nach oben, erstreckt. Die Antenne 12 befindet sich in dem Gehäuse 9 außerhalb der Vakuumkammer, welche um die Zylinder des Hohlraumresonators 1 herum angeordnet zu denken ist. Das Quarzfenster 14 schließt den Hohlraumresonator 1 nach oben ab, während die Behälterträgerplatte 5 den Abschluß nach unten vorn bildet.

Zur Speisung der zu beschichtenden Kunststoffflaschen mit Prozeßgas und zu ihrer Evakuierung gibt es zwei übereinanderliegende Räume, welche sich über die ganze Fläche einer Matrix oder einer Reihe von Flaschenvorrichtungen erstrecken, von denen in Figur 2 zwei Stück gezeigt sind. Zur Positionierung der Gaszuführrohre 13, für den Anschluß der flaschenförmigen Behälter 2 an Prozeßgas und Vakuum und zum Schließen des Hohlraumresonators 1 werden die Behälter, welche auf der gemeinsamen Behälterträgerplatte 5 positioniert sind, relativ zu einem Doppelraum 16/17 bewegt. Das Gaszuführrohr 13 jeder Einheit ist mit dem unteren Plenum oder Raum 16, dem Gasraum, verbunden. In diesen wird Prozeßgas durch mindestens eine Gaszuführleitung 18 zugeführt. Eingangsseitig weist jedes Gaszuführrohr 13 eine als Stellklappe oder Blende ausgestaltete Drossel 19 auf, durch welche der Fluß des Prozeßgases in den Behälter 2 hinein einstellbar ist.

Der Hals jeder zu behandelnden Flasche 2 (Behälter 2) ist mit dem oberen Plenum 17, einem Vakuumraum, verbunden. Dieser wird über eine Vakuumleitung 20 evakuiert, um in dem jeweiligen Behälter 2 einen reduzierten Druck zu erzeugen und auch aufrecht zu erhalten.

Nach der Plasmabehandlung werden die Behälterträgerplatte 5 mit den Behältern 2 und der Doppelraum 16/17 (unteres Plenum 16 und oberes Plenum 17) voneinander getrennt und dann können die flaschenförmigen Behälter 2 entfernt werden.

Die zweite Ausführungsform nach Figur 3 ist bis auf eine Ausnahme mit allen Teilen und Aufbauten der Ausführungsform der Figur 1 identisch. Die Ausnahme ist die Gestalt der Antenne 12. Diese hat gemäß den Figuren 3 und 4 die Form einer konischen Spirale. An dem Behälterboden 10 ist eine in den Raum des Gehäuses 9 hervorstehende hülsenförmige Aufnahme 21 befestigt, in welche das hintere, obere Ende 22 der Spiralantenne 12 durch Reibeingriff befestigt ist. Man sieht in Figur 4, wie dieses obere Ende 22 der Spiralantenne 12 gekrümmt ist, so daß ein Reibeingriff in der Aufnahme 21 ermöglicht wird, wenngleich der Außendurchmesser des oberen Endes 22 der Spiralantenne 12 kleiner ist als der Innendurchmesser der Sackbohrung in der Aufnahme 21.

Bei einer besonders bevorzugten Ausführungsform der Erfindung der Spiralantenne 12 beträgt der Abstand zwischen der vorderen unteren Oberfläche des Gehäusebodens 10 einerseits und der obersten ersten Windung der Spiralantenne 12 andererseits 50 mm. Der Durchmesser der obersten hinteren, größten Windung beträgt ebenfalls 50 mm, während die Länge der Spiralantenne 12 in Richtung der Längsachse der gesamten Anordnung 60 mm beträgt. Der Durchmesser der kleinsten Windung am vordersten untersten Ende der Spiralantenne 12 beträgt 22 mm.

### Bezugszeichenliste:

- 1: Hohlraumresonator
- 2: Behälter
- 3: Behandlungskammer
- 4: Hals des Behälters
- 5: Behälterträgerplatte
- 6: Loch in Behälterträgerplatte
- 7: Trennwand
- 8: Loch in der Trennwand
- 9: zylindermantelförmiges Gehäuse
- 10: Gehäuseboden
- 11: Mikrowellenzuführung
- 12: Antenne
- 13: Gaszuführrohr
- 14: Quarzfenster
- 15: Löcher im Gaszuführrohr
- 16/17: Doppelraum
- 16: unteres Plenum
- 17: oberes Plenum
- 18: Gaszuführleitung
- 19: Drossel
- 20: Vakuumleitung
- 21: Aufnahme
- 22: oberes Ende der Spiralantenne

## Patentansprüche

1. Anordnung zum Einkoppeln von Mikrowellenenergie in eine in einem Hohlraumresonator (1) befindliche Behandlungskammer (3), insbesondere eine Plasma-CVD-Beschichtungskammer (3), mit einer Mikrowellenzuführung (11) und einem Mikrowellenhohlleiter (9, 1), **dadurch gekennzeichnet, daß** die Anordnung einen im wesentlichen zylindrischen Aufbau derart hat, daß am hinteren Ende ein erster koaxialer Hohlleiter (im Bereich a) mit als Antenne (12) ausgebildetem Innenleiter vorgesehen ist, in der Mitte sich ein etwa zylindrischer Hohlleiter (im Bereich b) anschließt und am vorderen Ende (im Bereich c) ein zweiter koaxialer Hohlleiter (1) mit Innenleiter (13) vorgesehen ist, wobei in den zweiten koaxialen Hohlleiter (im Bereich c) durch ein Gaszuführrohr (13) Gas einführbar ist, welches durch die eingekoppelte Mikrowellenenergie in den Plasmazustand aktivierbar ist, und wobei durch die Antenne (12) im Plasmabereich (1, c) eine TM-Mode erzeugt wird.

2. Anordnung nach Anspruch 1, **dadurch gekennzeichnet, daß** die Antenne (12) des ersten koaxialen Hohlleiters (im Bereich a) Stabform hat und die Länge der Stabantenne (12) zwischen 40 mm und 100 mm liegt.

3. Anordnung nach Anspruch 1, **dadurch gekennzeichnet, daß** die Antenne (12) des ersten koaxialen Hohlleiters (im Bereich a) die Form einer konischen Spirale (Figur 4) hat und die Länge der Spiralantenne (12) zwischen 50 mm und 70 mm liegt.

4. Anordnung nach einem der Ansprüche 1 bis 3, **dadurch gekennzeichnet, daß** der Innenleiter (13) des zweiten koaxialen Leiters (im Bereich c) als Gaszuführrohr (13) ausgebildet und aus Metall hergestellt ist, welches von dem zu beschichtenden Kunststoffbehälter (2) umgeben ist, und daß der in der Behälterträgerplatte (5) gehalterte Behälter (2) die Behandlungskammer (2) bildet.

5. Anordnung nach einem der Ansprüche 1 bis 4, **dadurch gekennzeichnet, daß** in den sich in der Mitte der Anordnung befindenden zylindrischen Hohlleiter (im Bereich b) ein Quarzfenster (14) angebracht ist, das sich quer zu der Längsachse der Anordnung erstreckt.

6. Anordnung nach einem der Ansprüche 1 bis 5, **dadurch gekennzeichnet, daß** die Spiralantenne (12) mittels Reibeingriff lösbar in einer hülsenförmigen Aufnahme (21) befestigt ist.

## Claims

1. An arrangement for coupling microwave energy into a treatment chamber (3) disposed in a cavity resonator (1), in particular a plasma CVD coating chamber (3), comprising a microwave feed (11) and a microwave waveguide (9, 1) **characterised in that** the arrangement is of a substantially cylindrical structure, such that provided at the rear end is a first coaxial waveguide (in the region a) with an internal conductor in the form of an antenna (12), an approximately cylindrical waveguide (in the region b) follows in the centre of the arrangement and provided at the front end (in the region c) is a second coaxial waveguide (1) with internal conductor (13), wherein gas can be introduced through a gas feed tube (13) into the second coaxial waveguide (in the region c), which gas can be activated into the plasma state by the coupled-in microwave energy, and wherein a TM-mode is produced by the antenna (12) in the plasma region (1,c).

2. An arrangement according to claim 1 **characterised in that** the antenna (12) of the first coaxial waveguide (in the region a) is in bar form and the length of the bar antenna (12) is between 40 mm and 100 mm.

3. An arrangement according to claim 1 **characterised in that** the antenna (12) of the first coaxial waveguide (in the region a) is in the form of a conical spiral (Figure 4) and the length of the spiral antenna (12) is between 50 mm and 70 mm.

4. An arrangement according to one of claims 1 to 3 **characterised in that** the internal conductor (13) of the second coaxial conductor (in the region c) is in the form of a gas feed tube (13) and is made from metal which is surrounded by the plastic container (2) to be coated, and that the container (2) which is carried in the container carrier plate (5) forms the treatment chamber (2).

5. An arrangement according to one of claims 1 to 4 **characterised in that** disposed in the cylindrical waveguide (in the region b) which is in the centre of the arrangement is a quartz window (14) which extends transversely with respect to the longitudinal axis of the arrangement.

6. An arrangement according to one of claims 1 to 5 **characterised in that** the spiral antenna (12) is fixed releasably by means of frictional engagement in a sleeve-shaped receiving means (21).

## Revendications

1. Dispositif d'injection d'énergie micro-onde dans une chambre de traitement (3), notamment une chambre de revêtement par CVD au plasma (3), qui se trouve dans un résonateur à cavité, ledit dispositif comportant une amenée de micro-ondes (11) et un guide de micro-ondes creux (9, 1), **caractérisé en ce que** le dispositif a une structure sensiblement cylindrique de sorte qu'un premier guide creux coaxial (dans la région a) doté d'un guide intérieur conformé en antenne (12) est prévu à l'extrémité arrière, un guide creux sensiblement cylindrique (dans la région b) se raccorde au milieu et un deuxième guide creux coaxial (1) doté d'un guide intérieur (13) est prévu à l'extrémité avant (dans la région c), du gaz qui peut être activé à l'état plasma par l'énergie micro-onde injectée pouvant être introduit dans le deuxième guide creux coaxial (dans la région c) par un tube d'amenée de gaz (13) et un mode TM étant généré par l'antenne (12) dans la région à plasma (1, c).

2. Dispositif selon la revendication 1, **caractérisé en ce que** l'antenne (12) du premier guide creux coaxial a une forme de barre (dans la région a) et la longueur de l'antenne (12) en forme de barre est de 40 mm à 100 mm.

3. Dispositif selon la revendication 1, **caractérisé en ce que** l'antenne (12) du premier guide creux coaxial a (dans la région a) la forme d'une spirale conique (figure 4) et la longueur de l'antenne en spirale (12) est de 50 mm à 70 mm.

4. Dispositif selon l'une des revendications 1 à 3, **caractérisé en ce que** le guide intérieur (13) du deuxième guide coaxial est conformé (dans la région c) en tube d'amenée de gaz (13) et est fabriqué à partir d'un métal qui est entouré par le récipient en matière plastique (2) à revêtir, et **en ce que** le récipient (2) maintenu par la plaque de support de récipient (5) forme la chambre de traitement (2).

5. Dispositif selon l'une des revendications 1 à 4, **caractérisé en ce qu'**une fenêtre en quartz (14), qui s'étend transversalement à l'axe longitudinal du dispositif, est montée dans le guide creux cylindrique (dans la région b) qui se trouve au milieu du dispositif.

6. Dispositif selon l'une des revendications 1 à 5, **caractérisé en ce que** l'antenne en spirale (12) est fixée, de façon amovible par engagement par friction, dans un logement (21) en forme de manchon.
